# EUROPEAN PATENT APPLICATION

(11) **EP 4 184 535 A1**
(43) Date of publication of application: **24.05.2023**
(21) Application number: 21908415.9
(22) Date of filing: 20.04.2021
(51) Int. Cl.: H01F 41/02

(54) **MODIFIED NANOCRYSTALLINE STRIP, PREPARATION METHOD THEREFOR, AND APPLICATION THEREOF**

(30) Priority: 22.12.2020 CN 202011528665
(71) Applicant: Hengdian Group DMEGC Magnetics Co., Ltd., Jinhua, Zhejiang 322118 (CN)
(72) Inventor: LIU, Lidong, Jinhua, Zhejiang 322118 (CN); FU, Yaqi, Jinhua, Zhejiang 322118 (CN); TANG, Zishun, Jinhua, Zhejiang 322118 (CN); LI, Canwu, Jinhua, Zhejiang 322118 (CN)
(74) Representative: Cabinet Beaumont
(86) International application number: PCT/CN2021/088351
(87) International publication number: WO 2022/134404

(57) **Abstract**

Disclosed are a modified nanocrystalline strip, a preparation method therefor, and an application thereof. The preparation method comprises: performing rolling treatment on a nanocrystalline strip with a double-sided adhesive adhered on one side to obtain a micro-crushed nanocrystalline strip; performing acid etching surface treatment on the obtained micro-crushed nanocrystalline strip; performing alkaline washing surface treatment on the nanocrystalline strip subjected to acid etching surface treatment; sequentially washing with water and washing with alcohol the nanocrystalline strip obtained by the alkaline washing surface treatment, and then drying same; and performing micro-oxidation treatment on the dried nanocrystalline strip to obtain a modified nanocrystalline strip.

## Description

### TECHNICAL FIELD

The present application belongs to the technical field of materials and relates to a wireless charging material, a preparation method therefor and use thereof, and for example, relates to a modified nanocrystalline strip, a preparation method therefor and use thereof.

### BACKGROUND

In recent years, the wireless charging technology has gradually become a standard configuration for smartphones. A wireless charging receiver of a mobile phone is mainly composed of a coil and a magnetic sheet. The coil mainly receives an excitation magnetic field generated by a transmitting end and transforms the magnetic field into an alternating current. The magnetic sheet mainly plays a role of magnetic shielding and magnetic conducting, thereby improving charging efficiency of the entire system, and avoiding magnetic field leakage at the same time. Currently, wireless charging of the mobile phone mainly adopts the Qi standard with a use frequency of 100-200 kHz. The magnetic sheet of the receiver is mainly made of a ferrite and a nanocrystalline alloy, and the nanocrystalline magnetic sheet gradually becomes a mainstream due to its high saturation magnetization and high magnetic permeability.

The nanocrystalline alloy material has low resistivity, and high eddy current loss at high frequency. Therefore, in order to improve the resistivity and high-frequency characteristics of the nanocrystalline material and reduce the eddy current loss, it is common in the art to micro-crush the nanocrystalline strip. The micro-crushing of the nanocrystalline strip is generally achieved through roller-pressing by two metal rollers. A degree of the micro-crushing is controlled by a pattern of the roller-pressing, a pressure, the number of times of the roller-pressing and the like, and thereby a real part of magnetic permeability and an imaginary part of magnetic permeability of the strip are adjusted. Finally, several micro-crushed strip units are adhered together by double-sided tapes to form a composite magnetic sheet for the wireless charging receiver.

CN108597793A discloses a high-performance and high-frequency response composite magnetic material having a layered structure. The composite magnetic material is composed of a bottom layer material, a top layer material and an interlayer material which are stacked in sequence, where the bottom layer material is a black or matt black non-transparent double-sided pressure-sensitive tape, the top layer material is a black or matt black single-sided tape, and the interlayer material has a layered structure, which is formed by alternately stacking any two or three soft magnetic materials of a ferrite, a nanocrystalline and an amorphous.

CN108231381A discloses a magnetic conducting sheet structure for wireless charging, which includes a first magnetic layer and a second magnetic layer which are stacked in sequence, where magnetic permeability and thermal conductivity of the first magnetic layer are correspondingly less than magnetic permeability and thermal conductivity of the second magnetic layer, respectively. The first magnetic layer and the second magnetic layer are designed to have magnetic permeability gradient. The magnetic permeability of the second magnetic layer may be designed to be relatively high to improve shielding performance of the magnetic conducting sheet structure. The magnetic permeability of the first magnetic layer may be designed to be relatively low to reduce eddy current generation. The thermal conductivity gradually increases from the first magnetic layer to the second magnetic layer, improving temperature uniformity and heat dissipation performance of the magnetic conducting sheet structure.

The composite magnetic sheet structure composed of nanocrystalline strips has been widely applied to a wireless charging system of the mobile phone. However, there still exist some problems, or room for optimization: a microstructure of the micro-crushed nanocrystalline strip is not uniform enough, shapes and sizes of the crushed units are non-uniform, and insulation uniformity between the crushed units is also poor, which will lead to the phenomenon that the magnetic field is concentrated at a sharp corner and positions where the crushed units are in contact with each other, the magnetic field is distributed unevenly, and even serious localized heating occurs. The nanocrystalline material has good conductivity, and even after the micro-crushing treatment, the eddy current loss of the magnetic sheet is serious, which significantly limits a further improvement of the entire system efficiency. If the nanocrystalline strip is too micro-crushed, the crushed units will be small, which can effectively reduce the eddy current effect, but the magnetic permeability will also be reduced significantly, and both the magnetic shielding and the magnetic conducting effectiveness are deteriorated. The nanocrystalline strip, limited by its material, has an ordinary frequency characteristic, especially a loss characteristic at high frequency, which is specifically reflected at a relatively high imaginary part of magnetic permeability of the nanocrystalline strip, affecting the efficiency of the entire wireless charging system. At present, nanocrystalline composite magnetic sheets are mostly made of nanocrystalline strips having the same performance and specification, and there is still room for further optimization in structure.

Therefore, it is necessary to provide a wireless charging material having high magnetic permeability and low loss.

### SUMMARY

An object of the present application is to provide a modified nanocrystalline strip, a preparation method therefor and use thereof. The modified nanocrystalline strip has a lower imaginary part of magnetic permeability and a lower loss, and is more conducive to the wireless charging system obtaining high electrical energy transmission efficiency. When the modified nanocrystalline strip is applied to a nanocrystalline composite-structure magnetic sheet, the wireless charging system can have better electrical energy transmission efficiency.

To achieve the object, the present application adopts the technical solutions described below.

In a first aspect, the present application provides a method for preparing a modified nanocrystalline strip. The preparation method includes the steps described below:
(1) performing roller-pressing treatment on a nanocrystalline strip with a double-sided tape adhered to one side to obtain a micro-crushed nanocrystalline strip;
(2) performing acid corroding surface treatment on the micro-crushed nanocrystalline strip obtained in step (1);
(3) performing alkali washing surface treatment on the nanocrystalline strip after the acid corroding surface treatment in step (2);
(4) performing water washing, alcohol washing and drying in sequence on the nanocrystalline strip obtained through the alkali washing surface treatment in step (3); and
(5) performing micro-oxidation treatment on the dried nanocrystalline strip in step (4) to obtain the modified nanocrystalline strip.

The acid corroding surface treatment can corrode the nanocrystalline material. Acid corroding is more likely to occur at micro-crushed cracks and sharp corners rather than flat and smooth surfaces of the nanocrystalline strip, thereby improving insulation between micro-crushed units and modifying the shapes of the micro-crushed units.

The alkali washing surface treatment can subjected the residual acidic solution to chemical reaction. Since gaps between the micro-crushed units are very small, the excess acidic solution is not easy to be removed. The alkali washing surface treatment can effectively solve this problem.

The water washing can remove the salt generated by reacting the alkaline solution with the acidic solution. However, the nanocrystalline strip after the water washing is prone to rust or excess oxidation in the drying process. Through the alcohol washing, deionized water is effectively diluted by absolute ethanol, and a reaction between the deionized water and the nanocrystalline strip is avoided during the drying process.

The micro-oxidation treatment can form a thin oxide film on the surface of the nanocrystalline strip and at a cross section of each micro-crushed unit, effectively improving resistivity of the nanocrystalline strip and thus reducing the eddy current loss.

Optionally, the nanocrystalline strip includes 73.5wt% Fe, 13.5wt% Si, 9wt% B, 3wt% Nb and 1wt% Cu. A material of the nanocrystalline strip of the present application may be expressed as Fe_{73.5}Si_{13.5}B₉Nb₃Cu, where the subscript value is a percentage of each element to a total mass of the nanocrystalline strip.

The nanocrystalline strip of the present application is a nanocrystalline strip after annealing treatment. Under different annealing conditions, the obtained nanocrystalline strips will have different real part of magnetic permeability and different imaginary part of magnetic permeability.

Optionally, the roller-pressing in step (1) has a pressure of 60-70 kg, which may be, for example, 60 kg, 61 kg, 62 kg, 63 kg, 64 kg, 65 kg, 66 kg, 67 kg, 68 kg, 69 kg or 70 kg. However, the pressure is not limited to the listed values, and other unlisted values within this value range are also applicable.

The roller-pressing of the present application is performed in the conventional roller press in the art. A round roller of the roller press is in line contact with the nanocrystalline strip. The pressure of the roller-pressing is set to be 60-70 kg so that the nanocrystalline strip can be micro-crushed.

Optionally, the roller-pressing in step (1) is performed for 1-5 times, which may be, for example, once, twice, three times, four times or five times.

Optionally, the acid corroding surface treatment in step (2) includes: coating an acidic solution on the surface of the micro-crushed nanocrystalline strip for surface acid treatment, and after the treatment is completed, washing the micro-crushed nanocrystalline strip with deionized water.

Optionally, the acidic solution is a hydrochloric acid solution having a mass fraction of 0.5-1.2wt%.

The hydrochloric acid solution used for the acid corroding surface treatment has a mass fraction of 0.5-1.2wt%, which may be, for example, 0.5wt%, 0.6wt%, 0.7wt%, 0.8wt%, 0.9wt%, 1wt%, 1.1 wt% or 1.2wt%. However, the mass fraction is not limited to the listed values, and other unlisted values within this value range are also applicable.

Optionally, the surface acid treatment is performed for 3-8 min, which may be, for example, 3 min, 4 min, 5 min, 6 min, 7 min or 8 min. However, the time is not limited to the listed values, and other unlisted values within this value range are also applicable.

When the used hydrochloric acid solution has too low a mass fraction and/or the surface acid treatment is performed for a relatively short time, an effective acid corroding effect cannot be achieved. When the hydrochloric acid solution has too high a mass fraction and/or the surface acid treatment time is performed for too long a time, an excessive corrosion is caused, which deteriorates the magnetic permeability of the nanocrystalline strip. Although the eddy current loss can be reduced in some extent, the hysteresis loss is significantly increased, and a total loss does not decrease but increases.

Optionally, the alkali washing surface treatment in step (3) includes: coating an alkaline solution on the surface of the nanocrystalline strip after the acid corroding surface treatment for surface alkali treatment, and after the treatment is completed, washing the micro-crushed nanocrystalline strip with deionized water.

Optionally, the alkaline solution includes any one or a combination of at least two of a sodium bicarbonate solution, a potassium hydroxide solution or a sodium hydroxide solution, optionally a sodium hydroxide solution.

Optionally, the sodium hydroxide solution has a mass fraction of 0.5-2wt%, which may be, for example, 0.5wt%, 0.8wt%, 1wt%, 1.2wt%, 1.5wt%, 1.6wt%, 1.8wt% or 2wt%. However, the mass fraction is not limited to the listed values, and other unlisted values within this value range are also applicable.

Optionally, the surface alkali treatment is performed for 5-10 min, which may be, for example, 5 min, 6 min, 7 min, 8 min, 9 min or 10 min. However, the time is not limited to the listed values, and other unlisted values within this value range are also applicable.

When the used sodium hydroxide solution has too low a mass fraction and/or the surface alkali treatment is performed for too short a time, the object of removing the acidic solution cannot be achieved. When the sodium hydroxide solution has too high a concentration, a localized chemical reaction is strong, and the reaction is not uniform. When the surface alkali treatment is performed for too long a time, experiment and production costs are wasted.

Optionally, the water washing in step (4) is performed for at least three times, which may be, for example, three times, four times, five times, six times, seven times or eight times. However, the number of times is not limited to the listed values, and other unlisted values within this value range are also applicable.

Optionally, the alcohol washing in step (4) is to wash the strip at least three times with absolute ethanol, which may be, for example, three times, four times, five times, six times, seven times or eight times. However, the number of times is not limited to the listed values, and other unlisted values within this value range are also applicable.

Optionally, the micro-oxidation treatment in step (5) is performed in an oxygen atmosphere having an oxygen concentration of ≥ 85vol%.

The micro-oxidation treatment is performed in the oxygen atmosphere having an oxygen concentration of ≥ 85vol%, which may be, for example, 85vol%, 90vol%, 92vol%, 95vol%, 98vol% or 100vol%. However, the oxygen concentration is not limited to the listed values, and other unlisted values within this value range are also applicable.

Optionally, the micro-oxidation treatment in step (5) is performed at 60-85 °C, which may be, for example, 60 °C, 65 °C, 70 °C, 75 °C, 80 °C or 85 °C. However, the temperature is not limited to the listed values, and other unlisted values within this value range are also applicable.

Optionally, the micro-oxidation treatment in step (5) is performed for 15-30 min, which may be, for example, 15 min, 18 min, 20 min, 25 min, 28 min or 30 min. However, the time is not limited to the listed values, and other unlisted values within this value range are also applicable.

The micro-oxidation treatment can form a thin oxide film on the surface of the nanocrystalline strip and at the cross section of each micro-crushed unit, effectively improving the resistivity of the nanocrystalline strip and thus reducing the eddy current loss. If the oxygen concentration is too low, the treatment is performed at too low a temperature or performed for too short a time, the object of the micro-oxidation treatment cannot be effectively achieved. If the oxygen concentration is too high, the treatment is performed at too high a temperature or performed for too long a time, the excess oxidation is caused, which significantly deteriorates magnetic permeability of the nanocrystalline. Although the eddy current loss can be reduced in some extent, the hysteresis loss is significantly increased, and the total loss does not decrease but increases.

As an optional technical solution of the preparation method of the present application, the preparation method includes the steps described below:
(1) performing roller-pressing treatment on a nanocrystalline strip with a double-sided tape adhered to one side to obtain a micro-crushed nanocrystalline strip, where the nanocrystalline strip includes, in mass percent, 73.5wt% Fe, 13.5wt% Si, 9wt% B, 3wt% Nb and 1wt% Cu;
(2) performing acid corroding surface treatment on the micro-crushed nanocrystalline strip obtained in step (1): coating a hydrochloric acid solution having a mass fraction of 0.5-1.2wt% on the surface of the micro-crushed nanocrystalline strip for surface acid treatment for 3-8 min, and after the treatment is completed, washing the micro-crushed nanocrystalline strip with deionized water;
(3) performing alkali washing surface treatment on the nanocrystalline strip after the acid corroding surface treatment in step (2): coating a sodium hydroxide solution having a mass fraction of 0.5-2wt% on the surface of the nanocrystalline strip after the acid corroding surface treatment for surface alkali treatment for 5-10 min, and after the treatment is completed, washing the micro-crushed nanocrystalline strip with deionized water;
(4) performing water washing at least three times, absolute ethanol washing at least three times and drying in sequence on the nanocrystalline strip obtained through the alkali washing surface treatment in step (3); and
(5) performing micro-oxidation treatment on the dried nanocrystalline strip in step (4) in an oxygen atmosphere having an oxygen concentration of ≥ 85vol% for 15-30 min at 60-85 °C to obtain the modified nanocrystalline strip.

In a second aspect, the present application provides a modified nanocrystalline strip prepared through the method according to the first aspect.

In a third aspect, the present application provides use of the modified nanocrystalline strip according to the first aspect to manufacture a nanocrystalline composite-structure magnetic sheet. Optionally, the nanocrystalline composite-structure magnetic sheet includes a release film, a first modified nanocrystalline strip, a second modified nanocrystalline strip, a third modified nanocrystalline strip and a fourth modified nanocrystalline strip which are stacked in sequence.

A double-sided tape of the first modified nanocrystalline strip is connected to the release film, and a double-sided tape between two adjacent modified nanocrystalline strips is connected to the nanocrystalline strips.

The first modified nanocrystalline strip, the second modified nanocrystalline strip, the third modified nanocrystalline strip and the fourth modified nanocrystalline strip are each independently the modified nanocrystalline strip according to claim 7.

The release film of the present application is the conventional release film in the art and is not specifically limited in the present application.

Optionally, the modified nanocrystalline strip has a thickness of 18-22 µm, which may be, for example, 18 µm, 19 µm, 20 µm, 21 µm or 22 µm. However, the thickness is not limited to the listed values, and other unlisted values within this value range are also applicable.

Optionally, the double-sided tape has a thickness of 4-6 µm, which may be, for example, 4 µm, 4.5 µm, 5 µm, 5.5 µm or 6 µm. However, the thickness is not limited to the listed values, and other unlisted values within this value range are also applicable.

Optionally, the first modified nanocrystalline strip has a real part of magnetic permeability of 400-500 at a test frequency of 128 kHz, which may be, for example, 400, 420, 450, 480 or 500. However, the real part of magnetic permeability is not limited to the listed values, and other unlisted values within this value range are also applicable; the first modified nanocrystalline strip has an imaginary part of magnetic permeability of ≤ 40, which may be, for example, 5, 10, 15, 20, 25, 30, 35 or 40. However, the imaginary part of magnetic permeability is not limited to the listed values, and other unlisted values within this value range are also applicable.

Optionally, the second modified nanocrystalline strip has a real part of magnetic permeability of 600-800 at a test frequency of 128 kHz, which may be, for example, 600, 650, 700, 750 or 800. However, the real part of magnetic permeability is not limited to the listed values, and other unlisted values within this value range are also applicable; the second modified nanocrystalline strip has an imaginary part of magnetic permeability of ≤ 60, which may be, for example, 10, 20, 30, 40, 50 or 60. However, the imaginary part of magnetic permeability is not limited to the listed values, and other unlisted values within this value range are also applicable.

Optionally, the third modified nanocrystalline strip has a real part of magnetic permeability of 1000-1400 at a test frequency of 128 kHz, which may be, for example, 1000, 1050, 1100, 1150, 1200, 1250, 1300, 1350 or 1400. However, the real part of magnetic permeability is not limited to the listed values, and other unlisted values within this value range are also applicable; the third modified nanocrystalline strip has an imaginary part of magnetic permeability of ≤ 90, which may be, for example, 10, 20, 30, 40, 50, 60, 70, 80 or 90. However, the imaginary part of magnetic permeability is not limited to the listed values, and other unlisted values within this value range are also applicable.

Optionally, the fourth modified nanocrystalline strip has a real part of magnetic permeability of 5000-10000 at a test frequency of 128 kHz, which may be, for example, 5000, 6000, 7000, 8000, 9000 or 10000. However, the real part of magnetic permeability is not limited to the listed values, and other unlisted values within this value range are also applicable; the fourth modified nanocrystalline strip has an imaginary part of magnetic permeability of ≤ 170, which may be, for example, 100, 110, 120, 130, 140, 150, 160 or 170. However, the imaginary part of magnetic permeability is not limited to the listed values, and other unlisted values within this value range are also applicable.

The magnetic permeability in the present application is complex magnetic permeability obtained through a test using the E4990A analyzer. During the test, the nanocrystalline strip to be tested is cut into a ring having an outer diameter of 19.9 mm and an inner diameter of 8.8 mm. The higher the real part of magnetic permeability, the better the magnetically conductive performance; the higher the imaginary part of magnetic permeability, the greater the magnetic loss of the magnetic shielding sheet.

Magnetic performance of each nanocrystalline strip of the nanocrystalline composite-structure magnetic sheet in the present application is strictly limited to form the composite structure having a gradient magnetic conducting characteristic. The first modified nanocrystalline strip is closest to the wireless charging system receiver, which has a characteristic of relatively low loss to guarantee the efficiency of the wireless charging system. The outermost fourth modified nanocrystalline strip has a high real part of magnetic permeability, and the magnetic shielding effectiveness is excellent, thus avoiding a magnetic field radiation of the wireless charging system. In the present application, the synergy among the first modified nanocrystalline strip, the second modified nanocrystalline strip, the third modified nanocrystalline strip and the fourth modified nanocrystalline strip allows the nanocrystalline composite-structure magnetic sheet to possess good electrical energy transmission efficiency.

Compared with the existing art, the present application has the beneficial effects described below.
(1) Compared with the traditional preparation process of a nanocrystalline strip for wireless charging, the preparation method provided in the present application can give the modified nanocrystalline strip with a lower imaginary part of magnetic permeability and a lower loss which is more conducive to the wireless charging system obtaining high electrical energy transmission efficiency. In the present application, the acid corroding is performed on the micro-crushed nanocrystalline strip so that dilute hydrochloric acid enters into the micro-cracks, and the bridges between the micro-crushed units and the sharp corners of the micro-crushed units are corroded, optimizing the microstructure of the strip and avoiding the magnetic field concentrating and unevenly distributing during the working. Subsequently, the acid, salt (sodium chloride generated by the acid-base reaction) and deionized water remaining on the surface of the nanocrystalline strip are removed through the alkali washing, the water washing and the alcohol washing, and finally, an extremely thin oxide film is formed on surfaces and edges of the micro-crushed units in the nanocrystalline strip through the micro-oxidation treatment, improving insulation of the nanocrystalline strip and further reducing the eddy current loss of the nanocrystalline strip.
(2) The magnetic performance of each nanocrystalline strip of the nanocrystalline composite-structure magnetic sheet in the present application is strictly limited to form the composite structure having a gradient magnetic conducting characteristic. The first modified nanocrystalline strip is closest to the wireless charging system, which has a characteristic of relatively low loss to guarantee the efficiency of the wireless charging system. The outermost fourth modified nanocrystalline strip has a high real part of magnetic permeability, and the magnetic shielding effectiveness is excellent, thus avoiding the magnetic field radiation of the wireless charging system. That is, the synergy among the first modified nanocrystalline strip, the second modified nanocrystalline strip, the third modified nanocrystalline strip and the fourth modified nanocrystalline strip allows the nanocrystalline composite-structure magnetic sheet to possess good electrical energy transmission efficiency.

### BRIEF DESCRIPTION OF DRAWINGS

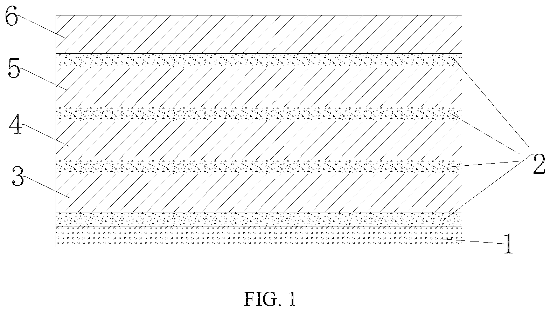

FIG. 1 is a structure diagram of a nanocrystalline composite-structure magnetic sheet provided by the present application.

### Reference list

- 1: release film
- 2: double-sided tape
- 3: first modified nanocrystalline strip
- 4: second modified nanocrystalline strip
- 5: third modified nanocrystalline strip
- 6: fourth modified nanocrystalline strip

### DETAILED DESCRIPTION

Technical solutions of the present application are further described below through specific examples. Those skilled in the art are to understand that the examples described herein are used for a better understanding of the present application and are not to be construed as specific limitations to the present application.

### Example 1

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

A double-sided tape 2 of the first modified nanocrystalline strip 3 is connected to the release film 1. A double-sided tape 2 between two adjacent modified nanocrystalline strips is connected to the nanocrystalline strips. The double-sided tape 2 has a thickness of 5 µm, and each modified nanocrystalline strip has a thickness of 20 µm.

The first modified nanocrystalline strip 3, the second modified nanocrystalline strip 4, the third modified nanocrystalline strip 5 and the fourth modified nanocrystalline strip 6 are each independently the modified nanocrystalline strip prepared through the following preparation method. The preparation method includes the steps described below.
(1) Roller-pressing treatment was performed on a nanocrystalline strip (Fe_{73.5}Si_{13.5}B₉Nb₃Cu, where the subscript value was a percentage of each element to a total mass of the nanocrystalline strip) with the double-sided tape 2 adhered to one side to obtain a micro-crushed nanocrystalline strip, where the roller-pressing treatment had a pressure of 60 kg, and the roller-pressing was performed for three times.
(2) Acid corroding surface treatment was performed on the micro-crushed nanocrystalline strip obtained in step (1): a hydrochloric acid solution having a mass fraction of 0.8wt% was coated on the surface of the micro-crushed nanocrystalline strip for surface acid treatment for 5 min, and after the treatment was completed, the nanocrystalline strip was washed with deionized water.
(3) Alkali washing surface treatment was performed on the nanocrystalline strip after the acid corroding surface treatment in step (2): a sodium hydroxide solution having a mass fraction of 1.5wt% was coated on the surface of the nanocrystalline strip after the acid corroding surface treatment for surface alkali treatment for 8 min, and after the treatment was completed, the nanocrystalline strip was washed with deionized water.
(4) Three times of water washing, three times of absolute ethanol washing and drying were performed in sequence on the nanocrystalline strip obtained through the alkali washing surface treatment in step (3).
(5) Micro-oxidation treatment was performed on the dried nanocrystalline strip in step (4) in an oxygen atmosphere having an oxygen concentration of 95vol% for 21 min at 75 °C to obtain the modified nanocrystalline strip.

Real parts µ' of magnetic permeability and imaginary parts µ" of magnetic permeability for the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 464.2 | 36.3 |
| Second modified nanocrystalline strip | 675.3 | 48.2 |
| Third modified nanocrystalline strip | 1275.7 | 82.6 |
| Fourth modified nanocrystalline strip | 9342.1 | 166.5 |

### Comparative Example 1

A nanocrystalline composite-structure magnetic sheet provided in this comparative example was the same as that in Example 1, except that a second modified nanocrystalline strip 4, a third modified nanocrystalline strip 5 and a fourth modified nanocrystalline strip 6 were replaced with a first modified nanocrystalline strip 3.

### Comparative Example 2

A nanocrystalline composite-structure magnetic sheet provided in this comparative example was the same as that in Example 1, except that a first modified nanocrystalline strip 3, a third modified nanocrystalline strip 5 and a fourth modified nanocrystalline strip 6 were replaced with a second modified nanocrystalline strip 4.

### Comparative Example 3

A nanocrystalline composite-structure magnetic sheet provided in this comparative example was the same as that in Example 1, except that a first modified nanocrystalline strip 3, a second modified nanocrystalline strip 4 and a fourth modified nanocrystalline strip 6 were replaced with a third modified nanocrystalline strip 5.

### Comparative Example 4

A nanocrystalline composite-structure magnetic sheet provided in this comparative example was the same as that in Example 1, except that a first modified nanocrystalline strip 3, a second modified nanocrystalline strip 4 and a third modified nanocrystalline strip 5 were replaced with a fourth modified nanocrystalline strip 6.

A charging efficiency test was performed using a P9221-EVK wireless charging system receiver apparatus manufactured by IDT, and power of the test system was 15 W, which met the Qi standard. During the test, the release film was removed, and the nanocrystalline composite-structure magnetic sheet was fixed on a back side of a coil to test electrical energy transmission efficiency. The results are shown in the table below.

| | Electrical Energy Transmission Efficiency (%) |
|---|---|
| Example 1 | 87.1 |
| Comparative Example 1 | 84.9 |
| Comparative Example 2 | 85.4 |
| Comparative Example 3 | 85.3 |
| Comparative Example 4 | 84.2 |

As can be seen from the above table, the electrical energy transmission efficiency of the wireless charging system using the composite-structure magnetic sheet having gradient magnetic permeability is higher than that of the wireless charging system using the traditional composite magnetic sheet having single magnetic permeability.

### Example 2

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

Real parts µ' of magnetic permeability and imaginary parts µ" of magnetic permeability for the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 492.6 | 38.9 |
| Second modified nanocrystalline strip | 758.2 | 55.7 |
| Third modified nanocrystalline strip | 1119.4 | 74.3 |
| Fourth modified nanocrystalline strip | 7435.9 | 144.1 |

The rest was the same as that in Example 1.

### Comparative Example 5

A nanocrystalline composite-structure magnetic sheet provided in this comparative example was the same as that in Example 2, except that a second modified nanocrystalline strip 4 was replaced with a first modified nanocrystalline strip 3, and a third modified nanocrystalline strip 5 and a fourth modified nanocrystalline strip 6 were replaced with a second modified nanocrystalline strip 4.

### Comparative Example 6

A nanocrystalline composite-structure magnetic sheet provided in this comparative example was the same as that in Example 2, except that a second modified nanocrystalline strip 4 was replaced with a first modified nanocrystalline strip 3 and a third modified nanocrystalline strip 5 was replaced with a fourth modified nanocrystalline strip 6.

### Comparative Example 7

A nanocrystalline composite-structure magnetic sheet provided in this comparative example was the same as that in Example 2, except that a first modified nanocrystalline strip 3 was replaced with a second modified nanocrystalline strip 4 and a third modified nanocrystalline strip 5 was replaced with a fourth modified nanocrystalline strip 6.

### Comparative Example 8

A nanocrystalline composite-structure magnetic sheet provided in this comparative example was the same as that in Example 2, except that a first modified nanocrystalline strip 3 and a second modified nanocrystalline strip 4 were replaced with a third modified nanocrystalline strip 5 and a third modified nanocrystalline strip 5 and a fourth modified nanocrystalline strip 6 were replaced with a second modified nanocrystalline strip 4.

### Comparative Example 9

A nanocrystalline composite-structure magnetic sheet provided in this comparative example was the same as that in Example 2, except that a fourth modified nanocrystalline strip 6 was replaced with a third modified nanocrystalline strip 5.

### Comparative Example 10

A nanocrystalline composite-structure magnetic sheet provided in this comparative example was the same as that in Example 2, except that a third modified nanocrystalline strip 5 was replaced with a fourth modified nanocrystalline strip 6.

A charging efficiency test was performed using a P9221-EVK wireless charging system receiver apparatus manufactured by IDT, and power of the test system was 15 W, which met the Qi standard. During the test, the release film was removed, and the nanocrystalline composite-structure magnetic sheet was fixed on a back side of a coil to test electrical energy transmission efficiency. The results are shown in the table below.

| | Electrical Energy Transmission Efficiency (%) |
|---|---|
| Example 2 | 87.3 |
| Comparative Example 5 | 84.6 |
| Comparative Example 6 | 85.7 |

| | |
|---|---|
| Comparative Example 7 | 85.5 |
| Comparative Example 8 | 84.7 |
| Comparative Example 9 | 86.1 |
| Comparative Example 10 | 85.9 |

As can be seen from the above table, the charging efficiency of Example 2 is higher than that of Comparative Examples 5-10, indicating that the composite-structure magnetic sheet having gradient magnetic permeability provided in the present application is the best in magnetic shielding and magnetic conducting effectiveness and optimal in structure.

### Example 3

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

A double-sided tape 2 of the first modified nanocrystalline strip 3 is connected to the release film 1. A double-sided tape 2 between two adjacent modified nanocrystalline strips is connected to the nanocrystalline strips. The double-sided tape 2 has a thickness of 5 µm, and each modified nanocrystalline strip has a thickness of 20 µm.

The first modified nanocrystalline strip 3, the second modified nanocrystalline strip 4, the third modified nanocrystalline strip 5 and the fourth modified nanocrystalline strip 6 are each independently the modified nanocrystalline strip prepared through the following preparation method. The preparation method includes the steps described below.
(1) Roller-pressing treatment was performed on a nanocrystalline strip (Fe_{73.5}Si_{13.5}B₉Nb₃Cu, where the subscript value was a percentage of each element to a total mass of the nanocrystalline strip) with the double-sided tape 2 adhered to one side to obtain a micro-crushed nanocrystalline strip, where the roller-pressing treatment had a pressure of 65 kg, and the roller-pressing was performed for five times.
(2) Acid corroding surface treatment was performed on the micro-crushed nanocrystalline strip obtained in step (1): a hydrochloric acid solution having a mass fraction of 1wt% was coated on the surface of the micro-crushed nanocrystalline strip for surface acid treatment for 5 min, and after the treatment was completed, the nanocrystalline strip was washed with deionized water.
(3) Alkali washing surface treatment was performed on the nanocrystalline strip after the acid corroding surface treatment in step (2): a sodium hydroxide solution having a mass fraction of 1.5wt% was coated on the surface of the nanocrystalline strip after the acid corroding surface treatment for surface alkali treatment for 9 min, and after the treatment was completed, the nanocrystalline strip was washed with deionized water.
(4) Three times of water washing, three times of absolute ethanol washing and drying were performed in sequence on the nanocrystalline strip obtained through the alkali washing surface treatment in step (3).
(5) Micro-oxidation treatment was performed on the dried nanocrystalline strip in step (4) in an oxygen atmosphere having an oxygen concentration of 90vol% for 28 min at 80 °C to obtain the modified nanocrystalline strip.

Real parts µ' of magnetic permeability and imaginary parts µ" of magnetic permeability of the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 436.6 | 27.9 |
| Second modified nanocrystalline strip | 711.1 | 52.7 |
| Third modified nanocrystalline strip | 1366.4 | 85.9 |
| Fourth modified nanocrystalline strip | 8856.2 | 158.4 |

### Comparative Example 11

A nanocrystalline composite-structure magnetic sheet provided in this comparative example was the same as that in Example 3, except that step (2), step (3), step (4) and step (5) were not performed when a first modified nanocrystalline strip 3 was prepared.

### Comparative Example 12

A nanocrystalline composite-structure magnetic sheet provided in this comparative example was the same as that in Example 3, except that a hydrochloric acid solution used in step (2) had a mass fraction of 0.45wt% when a first modified nanocrystalline strip 3 was prepared.

### Comparative Example 13

A nanocrystalline composite-structure magnetic sheet provided in this comparative example was the same as that in Example 3, except that a hydrochloric acid solution used in step (2) had a mass fraction of 1.4wt% when a first modified nanocrystalline strip 3 was prepared.

### Comparative Example 14

A nanocrystalline composite-structure magnetic sheet provided in this comparative example was the same as that in Example 3, except that surface acid treatment in step (2) was performed for 2.5 min when a first modified nanocrystalline strip 3 was prepared.

### Comparative Example 15

A nanocrystalline composite-structure magnetic sheet provided in this comparative example was the same as that in Example 3, except that surface acid treatment in step (2) was performed for 10 min when a first modified nanocrystalline strip 3 was prepared.

Magnetic permeability of the first modified nanocrystalline strips 3 obtained in Example 3 and Comparative Examples 11-15 and electrical energy transmission efficiency of the nanocrystalline composite-structure magnetic sheets are shown in the table below.

| | Real Part µ' of Magnetic Permeability | Imaginary Part µ" of Magnetic Permeability | Electrical Energy Transmission Efficiency (%) |
|---|---|---|---|
| Example 3 | 436.6 | 27.9 | 87.3 |
| Comparative Example 11 | 466.2 | 61.2 | 84.6 |
| Comparative Example 12 | 448.1 | 43.2 | 85.7 |
| Comparative Example 13 | 411.1 | 29.6 | 85.5 |
| Comparative Example 14 | 453.5 | 47.7 | 84.7 |
| Comparative Example 15 | 408.8 | 30.5 | 86.1 |

As can be seen from the above table, compared with the nanocrystalline strips 1 in Comparative Examples 11-15, the first modified nanocrystalline strip 3 in Example 3 has a relatively high real part of magnetic permeability, a relatively low imaginary part of magnetic permeability and higher electrical energy transmission efficiency. The results indicate that the method for preparing a nanocrystalline strip provided in the present application has a relatively good magnetic conducting and magnetic shielding function and a relatively low loss; and when the process parameters of the acid corroding surface treatment exceed a limited range, the nanocrystalline strip has a relatively poor magnetic shielding and magnetic conducting effectiveness, and the wireless charging system constituted by the nanocrystalline strip has relatively poor charging efficiency.

### Example 4

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

A double-sided tape 2 of the first modified nanocrystalline strip 3 is connected to the release film 1. A double-sided tape 2 between two adjacent modified nanocrystalline strips is connected to the nanocrystalline strips. The double-sided tape 2 has a thickness of 5 µm, and each modified nanocrystalline strip has a thickness of 20 µm.

The first modified nanocrystalline strip 3, the second modified nanocrystalline strip 4, the third modified nanocrystalline strip 5 and the fourth modified nanocrystalline strip 6 are each independently the modified nanocrystalline strip prepared through the following preparation method. The preparation method includes the steps described below.
(1) Roller-pressing treatment was performed on a nanocrystalline strip (Fe_{73.5}Si_{13.5}B₉Nb₃Cu, where the subscript value was a percentage of each element to a total mass of the nanocrystalline strip) with the double-sided tape 2 adhered to one side to obtain a micro-crushed nanocrystalline strip, where the roller-pressing treatment had a pressure of 62 kg, and the roller-pressing was performed for four times.
(2) Acid corroding surface treatment was performed on the micro-crushed nanocrystalline strip obtained in step (1): a hydrochloric acid solution having a mass fraction of 0.9wt% was coated on the surface of the micro-crushed nanocrystalline strip for surface acid treatment for 6 min, and after the treatment was completed, the nanocrystalline strip was washed with deionized water.
(3) Alkali washing surface treatment was performed on the nanocrystalline strip after the acid corroding surface treatment in step (2): a sodium hydroxide solution having a mass fraction of 1.2wt% was coated on the surface of the nanocrystalline strip after the acid corroding surface treatment for surface alkali treatment for 6 min, and after the treatment was completed, the nanocrystalline strip was washed with deionized water.
(4) Three times of water washing, three times of absolute ethanol washing and drying were performed in sequence on the nanocrystalline strip obtained through the alkali washing surface treatment in step (3).
(5) Micro-oxidation treatment was performed on the dried nanocrystalline strip in step (4) in an oxygen atmosphere having an oxygen concentration of 98vol% for 18 min at 70 °C to obtain the modified nanocrystalline strip.

Real parts µ' of magnetic permeability and imaginary parts µ" of magnetic permeability of the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 475.9 | 36.6 |
| Second modified nanocrystalline strip | 666.8 | 47.2 |
| Third modified nanocrystalline strip | 1178.9 | 81.2 |
| Fourth modified nanocrystalline strip | 9987.1 | 168.8 |

### Comparative Example 16

A nanocrystalline composite-structure magnetic sheet provided in this comparative example was the same as that in Example 4, except that alkali washing surface treatment in step (3) was not performed when a second modified nanocrystalline strip 4 was prepared.

### Comparative Example 17

A nanocrystalline composite-structure magnetic sheet provided in this comparative example was the same as that in Example 4, except that a sodium hydroxide solution used in step (3) had a mass fraction of 0.4wt% when a second modified nanocrystalline strip 4 was prepared.

### Comparative Example 18

A nanocrystalline composite-structure magnetic sheet provided in this comparative example was the same as that in Example 4, except that a sodium hydroxide solution used in step (3) had a mass fraction of 2.5wt% when a second modified nanocrystalline strip 4 was prepared.

### Comparative Example 19

A nanocrystalline composite-structure magnetic sheet provided in this comparative example was the same as that in Example 4, except that surface alkali treatment in step (3) was performed for 4.5 min when a second modified nanocrystalline strip 4 was prepared.

### Comparative Example 20

A nanocrystalline composite-structure magnetic sheet provided in this comparative example was the same as that in Example 4, except that surface alkali treatment in step (3) was performed for 12 min when a second modified nanocrystalline strip 4 was prepared.

Magnetic permeability of the second modified nanocrystalline strips 4 obtained in Example 4 and Comparative Examples 16-20 and electrical energy transmission efficiency of the nanocrystalline composite-structure magnetic sheets are shown in the table below.

| | Real Part µ' of Magnetic Permeability | Imaginary Part µ" of Magnetic Permeability | Electrical Energy Transmission Efficiency (%) |
|---|---|---|---|
| Example 4 | 666.8 | 47.2 | 87.2 |
| Comparative Example 16 | 612.4 | 45.3 | 85.9 |
| Comparative Example 17 | 631.1 | 46.4 | 86.1 |
| Comparative Example 18 | 642.1 | 47.1 | 86.3 |
| Comparative Example 19 | 644.6 | 48.6 | 86.1 |
| Comparative Example 20 | 662.7 | 48.2 | 87.1 |

As can be seen from the above table, compared with the nanocrystalline strips 2 in Comparative Examples 16-19, the second modified nanocrystalline strip 4 in Example 4 has a relatively high real part of magnetic permeability, a relatively low imaginary part of magnetic permeability and higher electrical energy transmission efficiency. The magnetic performance and the electrical energy transmission efficiency of the second modified nanocrystalline strip 4 in Comparative Example 20 are substantially equivalent to those in Example 4, indicating that the overlong alkali washing time brings no performance improvement but cost waste. Therefore, the method for preparing a nanocrystalline strip provided in the present application has a relatively good magnetic conducting and magnetic shielding function and a relatively low loss, and when the alkali washing process is not adopted or the process parameters of the alkali washing exceed a limited range, the nanocrystalline strip has a relatively poor magnetic shielding and magnetic conducting effectiveness, and the wireless charging system constituted by the nanocrystalline strip has relatively poor charging efficiency.

### Example 5

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

A double-sided tape 2 of the first modified nanocrystalline strip 3 is connected to the release film 1. A double-sided tape 2 between two adjacent modified nanocrystalline strips is connected to the nanocrystalline strips. The double-sided tape 2 has a thickness of 5 µm, and each modified nanocrystalline strip has a thickness of 20 µm.

The first modified nanocrystalline strip 3, the second modified nanocrystalline strip 4, the third modified nanocrystalline strip 5 and the fourth modified nanocrystalline strip 6 are each independently the modified nanocrystalline strip prepared through the following preparation method. The preparation method includes the steps described below.
(1) Roller-pressing treatment was performed on a nanocrystalline strip (Fe_{73.5}Si_{13.5}B₉Nb₃Cu, where the subscript value was a percentage of each element to a total mass of the nanocrystalline strip) with the double-sided tape 2 adhered to one side to obtain a micro-crushed nanocrystalline strip, where the roller-pressing treatment had a pressure of 60 kg, and the roller-pressing was performed for five times.
(2) Acid corroding surface treatment was performed on the micro-crushed nanocrystalline strip obtained in step (1): a hydrochloric acid solution having a mass fraction of 0.5wt% was coated on the surface of the micro-crushed nanocrystalline strip for surface acid treatment for 8 min, and after the treatment was completed, the nanocrystalline strip was washed with deionized water.
(3) Alkali washing surface treatment was performed on the nanocrystalline strip after the acid corroding surface treatment in step (2): a sodium hydroxide solution having a mass fraction of 2wt% was coated on the surface of the nanocrystalline strip after the acid corroding surface treatment for surface alkali treatment for 5 min, and after the treatment was completed, the nanocrystalline strip was washed with deionized water.
(4) Three times of water washing, three times of absolute ethanol washing and drying were performed in sequence on the nanocrystalline strip obtained through the alkali washing surface treatment in step (3).
(5) Micro-oxidation treatment was performed on the dried nanocrystalline strip in step (4) in an oxygen atmosphere having an oxygen concentration of 90vol% for 15 min at 85 °C to obtain the modified nanocrystalline strip.

Real parts µ' of magnetic permeability and imaginary parts µ" of magnetic permeability of the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 426.5 | 31.4 |
| Second modified nanocrystalline strip | 704.9 | 51.5 |
| Third modified nanocrystalline strip | 1299.3 | 84.6 |
| Fourth modified nanocrystalline strip | 8566.7 | 163.2 |

### Comparative Example 21

A nanocrystalline composite-structure magnetic sheet provided in this comparative example was the same as that in Example 5, except that alcohol washing in step (4) was not performed when a third modified nanocrystalline strip 5 was prepared.

Magnetic permeability of the third modified nanocrystalline strips 5 obtained in Example 5 and Comparative Example 21 and electrical energy transmission efficiency of the nanocrystalline composite-structure magnetic sheets are shown in the table below.

| | Real Part µ' of Magnetic Permeability | Imaginary Part µ" of Magnetic Permeability | Electrical Energy Transmission Efficiency (%) |
|---|---|---|---|
| Example 5 | 1299.3 | 84.6 | 86.9 |
| Comparative Example 21 | 1234.5 | 91.3 | 85.1 |

As can be seen from the above table, compared with the third modified nanocrystalline strip 5 in Comparative Example 21, the third modified nanocrystalline strip 5 in Example 5 has a relatively high real part of magnetic permeability, a relatively low imaginary part of magnetic permeability and higher electrical energy transmission efficiency. The results indicate that the alcohol washing is crucial in the preparation process of a nanocrystalline strip.

### Example 6

This example provides a nanocrystalline composite-structure magnetic sheet as shown in FIG. 1. The nanocrystalline composite-structure magnetic sheet includes a release film 1, a first modified nanocrystalline strip 3, a second modified nanocrystalline strip 4, a third modified nanocrystalline strip 5 and a fourth modified nanocrystalline strip 6 which are stacked in sequence.

A double-sided tape 2 of the first modified nanocrystalline strip 3 is connected to the release film 1. A double-sided tape 2 between two adjacent modified nanocrystalline strips is connected to the nanocrystalline strips. The double-sided tape 2 has a thickness of 5 µm, and each modified nanocrystalline strip has a thickness of 20 µm.

The first modified nanocrystalline strip 3, the second modified nanocrystalline strip 4, the third modified nanocrystalline strip 5 and the fourth modified nanocrystalline strip 6 are each independently the modified nanocrystalline strip prepared through the following preparation method. The preparation method includes the steps described below.
(1) Roller-pressing treatment was performed on a nanocrystalline strip (Fe_{73.5}Si_{13.5}B₉Nb₃Cu, where the subscript value was a percentage of each element to a total mass of the nanocrystalline strip) with the double-sided tape 2 adhered to one side to obtain a micro-crushed nanocrystalline strip, where the roller-pressing treatment had a pressure of 70 kg, and the roller-pressing was performed for one time.
(2) Acid corroding surface treatment was performed on the micro-crushed nanocrystalline strip obtained in step (1): a hydrochloric acid solution having a mass fraction of 1.2wt% was coated on the surface of the micro-crushed nanocrystalline strip for surface acid treatment for 3 min, and after the treatment was completed, the nanocrystalline strip was washed with deionized water.
(3) Alkali washing surface treatment was performed on the nanocrystalline strip after the acid corroding surface treatment in step (2): a sodium hydroxide solution having a mass fraction of 0.5wt% was coated on the surface of the nanocrystalline strip after the acid corroding surface treatment for surface alkali treatment for 10 min, and after the treatment was completed, the nanocrystalline strip was washed with deionized water.
(4) Three times of water washing, three times of absolute ethanol washing and drying were performed in sequence on the nanocrystalline strip obtained through the alkali washing surface treatment in step (3).
(5) Micro-oxidation treatment was performed on the dried nanocrystalline strip in step (4) in an oxygen atmosphere having an oxygen concentration of 85vol% for 30 min at 60 °C to obtain the modified nanocrystalline strip.

Real parts µ' of magnetic permeability and imaginary parts µ" of magnetic permeability of the first modified nanocrystalline strip 3, the second modified nanocrystalline strip 4, the third modified nanocrystalline strip 5 and the fourth modified nanocrystalline strip 6 are shown in the table below.

| | Real Part µ' of Magnetic Permeability | Imaginary Part µ" of Magnetic Permeability |
|---|---|---|
| First modified nanocrystalline strip | 431.2 | 32.5 |
| Second modified | 759.2 | 57.6 |
| nanocrystalline strip | | |
| Third modified nanocrystalline strip | 1365.9 | 88.6 |
| Fourth modified nanocrystalline strip | 9328.1 | 168.4 |

### Comparative Example 22

A nanocrystalline composite-structure magnetic sheet provided in this comparative example was the same as that in Example 6, except that micro-oxidation treatment in step (5) was not performed when a fourth modified nanocrystalline strip 6 was prepared.

### Comparative Example 23

A nanocrystalline composite-structure magnetic sheet provided in this comparative example was the same as that in Example 6, except that oxygen used in step (5) had a concentration of 83vol% when a fourth modified nanocrystalline strip 6 was prepared.

### Comparative Example 24

A nanocrystalline composite-structure magnetic sheet provided in this comparative example was the same as that in Example 6, except that micro-oxidation treatment in step (5) was performed at 55 °C when a fourth modified nanocrystalline strip 6 was prepared.

### Comparative Example 25

A nanocrystalline composite-structure magnetic sheet provided in this comparative example was the same as that in Example 6, except that micro-oxidation treatment in step (5) was performed at 90 °C when a fourth modified nanocrystalline strip 6 was prepared.

### Comparative Example 26

A nanocrystalline composite-structure magnetic sheet provided in this comparative example was the same as that in Example 6, except that micro-oxidation treatment in step (5) was performed for 12 min when a fourth modified nanocrystalline strip 6 was prepared.

### Comparative Example 27

A nanocrystalline composite-structure magnetic sheet provided in this comparative example was the same as that in Example 6, except that micro-oxidation treatment in step (5) was performed for 35 min when a fourth modified nanocrystalline strip 6 was prepared.

Magnetic permeability of the fourth modified nanocrystalline strips 6 obtained in Example 6 and Comparative Examples 22-27 and electrical energy transmission efficiency of the nanocrystalline composite-structure magnetic sheets are shown in the table below.

| | Real Part µ' of Magnetic Permeability | Imaginary Part µ" of Magnetic Permeability | Electrical Energy Transmission Efficiency (%) |
|---|---|---|---|
| Example 6 | 9328.1 | 168.4 | 87.0 |
| Comparative Example 22 | 9567.3 | 205.6 | 84.8 |
| Comparative Example 23 | 9512.6 | 197.3 | 85.2 |
| Comparative Example 24 | 9523.0 | 194.2 | 85.4 |
| Comparative Example 25 | 8977.6 | 178.6 | 84.2 |
| Comparative Example 26 | 9455.9 | 178.2 | 85.5 |
| Comparative Example 27 | 9035.4 | 181.2 | 84.5 |

As can be seen from the above table, compared with the fourth modified nanocrystalline strips 6 in Comparative Examples 22-27, the fourth modified nanocrystalline strip 6 in Example 6 has a relatively high real part of magnetic permeability, a relatively low imaginary part of magnetic permeability and higher electrical energy transmission efficiency. The results indicate that whether the micro-oxidation and the limitation of the micro-oxidation process parameters are introduced seriously affects the magnetic performance and the electrical energy transmission efficiency of the nanocrystalline strip.

In conclusion, compared with the traditional preparation process of a nanocrystalline strip for wireless charging, the preparation method provided in the present application can give the modified nanocrystalline strip with a lower imaginary part of magnetic permeability and a lower loss which is more conducive to the wireless charging system obtaining high electrical energy transmission efficiency. In the present application, the acid corroding is performed on the micro-crushed nanocrystalline strip so that dilute hydrochloric acid enters into micro-cracks, and the bridges between micro-crushed units and sharp corners of the micro-crushed units are corroded, optimizing the microstructure of the strip and avoiding the magnetic field concentrating or unevenly distributing during the work. Subsequently, the acid, salt (sodium chloride generated by an acid-base reaction) and deionized water remaining on the surface of the nanocrystalline strip are removed through the alkali washing, the water washing and the alcohol washing, and finally, an extremely thin oxide film is formed on surfaces and edges of the micro-crushed units in the nanocrystalline strip through the micro-oxidation treatment, improving insulation of the nanocrystalline strip and further reducing eddy current loss of the nanocrystalline strip.

The magnetic performance of each nanocrystalline strip of the nanocrystalline composite-structure magnetic sheet in the present application is strictly limited to form the composite structure having a gradient magnetic conducting characteristic. The first modified nanocrystalline strip is closest to the wireless charging system, which has a characteristic of relatively low loss to guarantee the efficiency of the wireless charging system. The outermost fourth modified nanocrystalline strip has a high real part of magnetic permeability, and the magnetic shielding effectiveness is excellent, avoiding a magnetic field radiation of the wireless charging system. That is, the synergy among the first modified nanocrystalline strip, the second modified nanocrystalline strip, the third modified nanocrystalline strip and the fourth modified nanocrystalline strip allows the nanocrystalline composite-structure magnetic sheet to possess good electrical energy transmission efficiency.

The applicant states that the preceding are merely specific examples of the present application and are not to limit the protection scope of the present application.

## Claims

1. A method for preparing a modified nanocrystalline strip, comprising:
(1) performing roller-pressing treatment on a nanocrystalline strip with a double-sided tape adhered to one side to obtain a micro-crushed nanocrystalline strip;
(2) performing acid corroding surface treatment on the micro-crushed nanocrystalline strip obtained in step (1);
(3) performing alkali washing surface treatment on the nanocrystalline strip after the acid corroding surface treatment in step (2);
(4) performing water washing, alcohol washing and drying in sequence on the nanocrystalline strip obtained through the alkali washing surface treatment in step (3); and
(5) performing micro-oxidation treatment on the dried nanocrystalline strip in step (4) to obtain the modified nanocrystalline strip.

2. The preparation method according to claim 1, wherein the nanocrystalline strip comprises, in mass percent, 73.5wt% Fe, 13.5wt% Si, 9wt% B, 3wt% Nb and 1wt% Cu.

3. The preparation method according to claim 1 or 2, wherein the roller-pressing in step (1) has a pressure of 60-70 kg.

4. The preparation method according to any one of claims 1 to 3, wherein the roller-pressing in step (1) is performed for 1-5 times;
optionally, the acid corroding surface treatment in step (2) comprises: coating an acidic solution on the surface of the micro-crushed nanocrystalline strip for surface acid treatment, and after the treatment is completed, washing the micro-crushed nanocrystalline strip with deionized water;
optionally, the acidic solution is a hydrochloric acid solution having a mass fraction of 0.5-1.2wt%;
optionally, the surface acid treatment is performed for 3-8 min.

5. The preparation method according to any one of claims 1 to 4, wherein the alkali washing surface treatment in step (3) comprises: coating an alkaline solution on the surface of the nanocrystalline strip after the acid corroding surface treatment for surface alkali treatment, and after the treatment is completed, washing the micro-crushed nanocrystalline strip with deionized water;
optionally, the alkaline solution comprises any one or a combination of at least two of a sodium bicarbonate solution, a potassium hydroxide solution or a sodium hydroxide solution, optionally a sodium hydroxide solution;
optionally, the sodium hydroxide solution has a mass fraction of 0.5-2wt%;
optionally, the surface alkali treatment is performed for 5-10 min.

6. The preparation method according to any one of claims 1 to 5, wherein the water washing in step (4) is performed for at least three times;
optionally, the alcohol washing in step (4) is to wash the strip at least three times with absolute ethanol;
optionally, the micro-oxidation treatment in step (5) is performed in an oxygen atmosphere having an oxygen concentration of ≥ 85vol%;
optionally, the micro-oxidation treatment in step (5) is performed at 60-85 °C;
optionally, the micro-oxidation treatment in step (5) is performed for 15-30 min.

7. The preparation method according to any one of claims 1 to 6, comprising:
(1) performing roller-pressing treatment on a nanocrystalline strip with a double-sided tape adhered to one side to obtain a micro-crushed nanocrystalline strip, wherein the nanocrystalline strip comprises, in mass percent, 73.5wt% Fe, 13.5wt% Si, 9wt% B, 3wt% Nb and 1wt% Cu;
(2) performing acid corroding surface treatment on the micro-crushed nanocrystalline strip obtained in step (1): coating a hydrochloric acid solution having a mass fraction of 0.5-1.2wt% on the surface of the micro-crushed nanocrystalline strip for surface acid treatment for 3-8 min, and after the treatment is completed, washing the micro-crushed nanocrystalline strip with deionized water;
(3) performing alkali washing surface treatment on the nanocrystalline strip after the acid corroding surface treatment in step (2): coating a sodium hydroxide solution having a mass fraction of 0.5-2wt% on the surface of the nanocrystalline strip after the acid corroding surface treatment for surface alkali treatment for 5-10 min, and after the treatment is completed, washing the micro-crushed nanocrystalline strip with deionized water;
(4) performing water washing at least three times, absolute ethanol washing at least three times and drying in sequence on the nanocrystalline strip obtained through the alkali washing surface treatment in step (3); and
(5) performing micro-oxidation treatment on the dried nanocrystalline strip in step (4) in an oxygen atmosphere having an oxygen concentration of ≥ 85vol% for 15-30 min at 60-85 °C to obtain the modified nanocrystalline strip.

8. A modified nanocrystalline strip prepared through the method according to any one of claims 1 to 7.

9. Use of the modified nanocrystalline strip according to claim 8 to manufacture a nanocrystalline composite-structure magnetic sheet.

10. The use according to claim 9, wherein the nanocrystalline composite-structure magnetic sheet comprises a release film, a first modified nanocrystalline strip, a second modified nanocrystalline strip, a third modified nanocrystalline strip and a fourth modified nanocrystalline strip which are stacked in sequence;
a double-sided tape of the first modified nanocrystalline strip is connected to the release film, and a double-sided tape between two adjacent modified nanocrystalline strips is connected to the nanocrystalline strips;
the first modified nanocrystalline strip, the second modified nanocrystalline strip, the third modified nanocrystalline strip and the fourth modified nanocrystalline strip are each independently the modified nanocrystalline strip according to claim 7.

11. The use according to claim 9 or 10, wherein the modified nanocrystalline strip has a thickness of 18-22 µm;
optionally, the double-sided tape has a thickness of 4-6 µm;
optionally, the first modified nanocrystalline strip has a real part of magnetic permeability of 400-500 and an imaginary part of magnetic permeability of ≤ 40 at a test frequency of 128 kHz;
optionally, the second modified nanocrystalline strip has a real part of magnetic permeability of 600-800 and an imaginary part of magnetic permeability of ≤ 60 at a test frequency of 128 kHz;
optionally, the third modified nanocrystalline strip has a real part of magnetic permeability of 1000-1400 and an imaginary part of magnetic permeability of ≤ 90 at a test frequency of 128 kHz;
optionally, the fourth modified nanocrystalline strip has a real part of magnetic permeability of 5000-10000 and an imaginary part of magnetic permeability of ≤ 170 at a test frequency of 128 kHz.
